# EUROPÄISCHE PATENTSCHRIFT

(11) **EP 4 332 665 B1**
(45) Veröffentlichungstag und Bekanntmachung des Hinweises auf die Patenterteilung: **13.08.2025**
(21) Anmeldenummer: 24152158.2
(22) Anmeldetag: 01.06.2016
(51) Int. Cl.: G02C 7/02, G03H 1/00, G02B 27/01

(54) **BRILLENGLAS UND VERFAHREN ZUR HERSTELLUNG EINES BRILLENGLASES**
SPECTACLE LENS AND METHOD FOR PRODUCING A SPECTACLE LENS
VERRE DE LUNETTES ET PROCÉDÉ DE FABRICATION D'UN VERRE DE LUNETTES

(30) Priorität: 17.06.2015 DE 102015109703
(43) Veröffentlichungstag der Anmeldung: 06.03.2024
(62) Teilanmeldung aus: 16726322.7
(73) Patentinhaber: tooz technologies GmbH, 73430 Aalen (DE)
(72) Erfinder: PÜTZ, Jörg, 73431 Aalen (DE); RIFAI, Katharina, 72072 Tübingen (DE); LINDIG, Karsten, 99084 Erfurt (DE)
(74) Vertreter: Kraus & Lederer PartGmbB

(56) Entgegenhaltungen:
- US-A- 4 830 441
- US-A- 5 432 623
- US-A- 6 139 147
- US-A1- 2001 055 094

## Beschreibung

### TECHNISCHES GEBIET

Ausführungsformen der Erfindung betreffen ein Verfahren zur Herstellung eines Brillenglases. Insbesondere betreffen verschiedene Ausführungsformen Techniken zum Ausbilden einer HOE-fähigen Polymerschicht, die auf einem Substrat des Brillenglases angeordnet ist, und die geeignet ist, um ein Holographisch-Optisches-Element auszubilden.

### HINTERGRUND

Die US 5 432 623 A offenbart ein Verfahren zur Herstellung einer optischen Qualitätslinse mit integraler Beschichtung eines holographischen Aufzeichnungsmaterials. Das Verfahren umfasst das Herstellen eines Linsenelements und das Eintauchen des Linsenelements in eine Lösung eines flüssigen holographischen Aufzeichnungsmaterials. Das Linsenelement wird dann aus der Lösung entfernt und übrigbleibende lösliche Komponenten der Beschichtung können anschließend verdampfen. Darüber hinaus wird ein weiteres Verfahren zum Herstellen einer optischen Qualitätslinse beschrieben, welches das Platzieren von mehreren Tropfen einer Lösung eines flüssigen holographischen Aufzeichnungsmaterials auf einer polierten, nicht klebenden Oberfläche, wie beispielsweise Teflon, umfasst. Dann wird die Oberfläche des zu beschichtenden Linsenelements in Kontakt mit dieser Flüssigkeit gebracht, wodurch bewirkt wird, dass sich diese gleichförmig zwischen der Oberfläche des Linsenelements und der Oberfläche verteilt. Anschließend kann das Linsenelement von der Oberfläche entfernt werden.

Die US 2004/108971 A1 beschreibt eine auf einem Kopf zu tragende Vorrichtung, um ein Bild zum Auge zu übertragen, wobei schaltbare holographische optische Elemente eingesetzt werden. Darüber hinaus wird eine Augen-Verfolgungsfunktionalität offenbart. Diese kann mittels einer Anordnung von Emittern und Detektoren auf einem Schirm, der vor einem Bildschirm angeordnet ist, erreicht werden. Die Emitter emittieren Strahlung. In einer weiteren Ausführungsform kann eine dynamische optische Vorrichtung ein elektrisch schaltbares holographisches Kompositmaterial sein. Dieses umfasst eine Anzahl von Schichten, wobei jede Schicht eine Vielzahl von voraufgezeichneten holographischen Elementen, die als Brechungsgitter agieren, umfasst.

Die US 2015/153484 A1 offenbart eine optische Linse, welche aus transparentem Kunststoff hergestellt ist und eine Beschichtung aufweist, welche mehrere Schichten umfasst. Darüber hinaus ist eine hartbeschichtete Schicht benachbart zu dem Linsenelement ausgebildet.

Die US 6 139 147 A beschreibt eine multifokale optische Linse, welche ein erstes optisches Element, welches eine erste optische Leistung bereitstellt, und ein zweites optisches Element, welches eine zweite optische Leistung bereitstellt, aufweist. Das zweite optische Element ist ein holographisches optisches Element, welches programmiert ist, um einfallendes Licht zu fokussieren.

Die JP 2007 286472 A beschreibt ein Herstellungsverfahren eines Holographisch-Optischen-Elements. Dabei wird auch ein Brillenglas mit einem Holographisch-Optischen-Element erwähnt.

Die JP H10 133554 A offenbart ein reflektierendes Holographisch-Optisches-Element und ein Herstellungsverfahren für ein solches Holographisch-Optisches-Element. Dabei wird auch ein Brillenglas mit einem Holographisch-Optischen-Element erwähnt.

Es sind Techniken zur Herstellung von optischen Bauelementen, die ein Holographisch-Optisches-Element (HOE) ausbilden, bekannt. HOEs bezeichnen typischerweise solche optischen Bauelemente, bei denen die holographischen Eigenschaften dazu verwendet werden, einen bestimmten Strahlengang des Lichts, wie z.B. Fokussierung bzw. Sammelung, Zerstreuung, und/oder Spiegelung, etc. zu erreichen. Dadurch können bestimmte optische Funktionalitäten implementiert werden. Die holographischen Eigenschaften wiederum nutzen den Wellencharakter des Lichts aus, insbesondere Kohärenz- und Interferenzeffekte. Dabei wird sowohl die Intensität, als auch die Phase des Lichts berücksichtigt.

Z.B. sind aus der Druckschrift US 2001/0055094 A1 Techniken bekannt, bei denen eine optische Linse aus polymerisierbarem Material in einer Gussform ausgebildet wird. Solche Techniken weisen jedoch verschiedene Einschränkungen bzw. Nachteile auf. Z.B. sind die polymerisierbaren Materialien, die geeignet sind, um ein HOE auszubilden, typischerweise vergleichsweise weich und wenig starr bzw. fest. Dies kann insbesondere im Zusammenhang mit Brillengläsern zu einer erhöhten Anfälligkeit gegenüber externen Belastungen, wie z.B. bei einem Sturz oder gegenüber abrasiven Medien, führen. Dadurch kann eine Belastbarkeit des Brillenglases eingeschränkt sein. Ferner können die optischen Funktionalitäten, die durch ein derartiges Brillenglas basierend auf den holographischen Eigenschaften implementiert werden können, wie z.B. die Brechkraft, Korrektur von Astigmatismen des Auges, chromatische Korrektur, Korrekturen höherer Ordnungen oder mit dem Blickwinkel variierende Korrekturen etc. eingeschränkt sein.

### ZUSAMMENFASSUNG

Deshalb besteht ein Bedarf für verbesserte Brillengläser und für verbesserte Verfahren zur Herstellung entsprechender Brillengläser. Insbesondere besteht ein Bedarf für solche Techniken, die zumindest einige der oben genannten Nachteile beheben. Insbesondere besteht ein Bedarf für vergleichsweise robuste und wenig fehleranfällige Brillengläser, die ein HOE enthalten / aufnehmen können.

Gemäß einem Aspekt betrifft die Erfindung ein Brillenglas. Das Brillenglas umfasst ein transparentes Substrat. Das Brillenglas umfasst ferner mindestens eine HOE-fähige Polymerschicht, die geeignet ist, um ein HOE auszubilden. Die mindestens eine HOE-fähige Polymerschicht ist auf dem transparenten Substrat angeordnet.

Das Substrat kann transparent für sichtbares Licht sein; Transmission des sichtbaren Lichts kann also zumindest teilweise durch das Substrat erfolgen. Das transparente Substrat kann z.B. einzelne spektrale Bereiche des Lichts stärker absorbieren als andere Bereiche; derart kann eine selektive Transmission implementiert werden. Das Substrat kann dem Brillenglas eine mechanische Grundstruktur geben und eine gewisse mechanische Belastbarkeit des Brillenglases erreichen. Das Substrat kann auch optische Funktionalitäten des Brillenglases implementieren. Z.B. kann das Substrat eine optische Linse ausbilden. Dadurch kann z.B. eine bestimmte Brechkraft des Brillenglases erreicht werden. Dadurch können Sehfehler eines Auges eines Benutzers kompensiert bzw. korrigiert werden.

Es können spezielle optische Mineralgläser und Polymere als Material für das Substrat verwendet werden. Das transparente Polymersubstrat z.B. kann aus folgender Gruppe ausgewählt sein: Polyallyldiglycolcarbonat (ADC); Polyurethane (PUR); Acrylat- und Allyl-Systeme; Polythiourethane (PTU); Episulfid/Thiol-Systeme; Thermoplaste wie z.B. Polycarbonat oder Polyamide. Eine Mittendicke des Substrats kann z.B. im Bereich von 1 - 3 mm liegen und bevorzugt ca. 2 mm betragen. Derart kann das transparente Substrat eine vergleichsweise hohe Robustheit des Brillenglases bereitstellen. Außerdem kann es möglich sein, bestimmte optische Funktionalitäten zu implementieren. Die Dicke des Substrats kann als Funktion des Ortes variieren.

Die mindestens eine HOE-fähige Polymerschicht kann auf verschiedenste Arten und Weisen auf dem Substrat angeordnet sein. Z.B. kann die mindestens eine HOE-fähige Polymerschicht unmittelbar angrenzend an das Substrat angeordnet sein. Es wäre aber auch möglich, dass weitere Schichten zwischen der mindestens einen HOE-fähigen Polymerschicht und dem Substrat angeordnet sind, z.B. eine Primer-Schicht zur Verbesserung der Haftung des Polymers auf dem Substrat. Es wäre alternativ oder zusätzlich auch möglich, dass sich zwischen der HOE-fähigen Polymerschicht und dem Substrat eine Fixierungsschicht zur Fixierung der HOE-fähigen Polymerschicht auf dem Substrat befindet.

Durch das Anordnen der mindestens einen HOE-fähigen Polymerschicht auf dem Substrat kann es möglich sein, dass das Brillenglas insgesamt - trotz des typischerweise vergleichsweise weichen Materials der mindestens einen HOE-fähigen Polymerschicht - eine hohe Robustheit aufweist. Das Brillenglas kann insbesondere vergleichsweise bruchstabil ausgestaltet sein.

Die HOE-fähige Polymerschicht kann z.B. eine Matrix aus einem bestimmten Polymer (Polymermatrix) umfassen. Diese Polymermatrix kann der Polymerschicht eine gewisse Struktur verleihen.

Die HOE-fähige Polymerschicht kann nach geeigneter Belichtung und/oder weitere Bearbeitungsschritte das HOE in der HOE-fähigen Polymerschicht ausbilden. Dann kann die mindestens eine HOE-fähige Polymerschicht ein HOE-Polymer umfassen. Das HOE-Polymer kann z.B. in die Polymermatrix eingebettet sein; insbesondere kann das HOE-Polymer verschieden von dem bestimmten Polymer sein, dass die Polymermatrix ausbildet. Induzierte lokale Dichtevariationen von Ketten des HOE-Polymers bewirken typischerweise eine lokale Variation des Brechungsindex der HOE-fähigen Polymerschicht und bilden derart das HOE aus. Eine entsprechende Struktur des HOE-Polymers kann z.B. durch eine geeignete Belichtung einer fotoreaktiven Komponente erreicht werden. Damit die mindestens eine HOE-fähige Polymerschicht geeignet ist, um das HOE auszubilden, kann die mindestens eine HOE-fähige Polymerschicht die fotoreaktive Komponente oder mehrere fotoreaktive Komponenten umfassen. Die einzelnen Moleküle der fotoreaktiven Komponente können z.B. in der Polymermatrix eingebettet sein. Die fotoreaktive Komponente kann ein Polymer-Edukt umfassen. Das Polymer-Edukt kann in das voranstehend genannte HOE-Polymer, welches letztendlich das HOE ausbildet, überführt werden. Das Überführen kann durch Verkettung und/oder Vernetzung kürzerer Moleküle des Polymer-Edukts erfolgen. Das Überführen könnte auch Umordnung von bereits verketteten und/oder vernetzten Molekülen des Polymer-Edukts umfassen. Z.B. kann das Polymer-Edukt ein Photopolymer oder ein Photomonomer sein.

Z.B. kann die fotoreaktive Komponente einen Farbstoff umfassen; z.B. können einzelne Moleküle des Farbstoffs an einzelne Moleküle des Polymer-Edukts gekoppelt sein. Es ist auch möglich, dass die fotoreaktive Komponente weitere Bestandteile, wie z.B. Initiatoren etc. umfasst. Durch den Farbstoff und/oder den Initiator kann erreicht werden, dass das Polymer-Edukt bei Beleuchtung mit Licht einer vorgegebenen Wellenlänge in das HOE-Polymer umgewandelt wird. Die einzelnen Moleküle des Polymer-Edukts können - in einem Zustand, in dem die mindestens eine HOE-fähige Polymerschicht das HOE nicht ausbildet - unverkettet oder unvernetzt sein, vergleichsweise kurze Ketten von Molekülen oder Netzwerke ausbilden und/oder speziell angeordnete Ketten oder Netzwerke von Molekülen ausbilden. Moleküle des Polymer-Edukts können durch Belichtung in einem geeigneten Wellenlängenbereich vernetzt und/oder umgeordnet werden, sodass das HOE-Polymer gegenüber dem Polymer-Edukt eine veränderte Struktur und/oder Verteilung aufweist.

Durch eine solche Polymerisation kann sich der Brechungsindex der mindestens einen HOE-fähige Polymerschicht lokal gegenüber einem Wert für die nicht-belichteten Polymerschicht ändern.

Z.B. kann das Brillenglas weiterhin eine Diffusionssperrschicht aufweisen. Die Diffusionssperrschicht kann unmittelbar angrenzen an die HOE-fähige Polymerschicht. Die Diffusionsschicht kann verhindern, dass das HOE-Polymer bzw. die fotoreaktive Komponente über der Zeit diffundiert.

Im Allgemeinen sind verschiedenste Möglichkeiten in der Anwendung des HOEs zur Implementierung optischer Funktionalitäten möglich. Z.B. kann die optische Funktionalität aus folgender Gruppe ausgewählt sein: eine Linse; ein Spiegel; ein wellenlängenspezifischer Spiegel; ein Prisma; ein transflektiver Strahlvereiniger; eine Sammellinse; eine Streulinse; ein Hohlspiegel; ein Wölbespiegel; ein Farbfilter; eine Datenbrille; und Kombinationen aus obengenanntem.

Zum Beispiel können vergleichsweise komplexe optische Korrekturen zur Kompensation von Sehfehlern des Auges durch das HOE implementiert werden. Diesbezüglich ist es z.B. möglich, dass eine optische Funktionalität des Brillenglases, welches eine Kompensation von Sehfehlern des Auges betrifft, sowohl durch das HOE, als auch durch eine Linseneigenschaft des Substrats beeinflusst wird. Das Substrat und das HOE können also zusammenwirken, um die optische Funktionalität zu implementieren. Ein Kombinationseffekt kann erzielt werden. Derart können besonders komplexe optische Funktionalitäten implementiert werden.

Z.B. kann das HOE zur Implementierung einer Bilderzeugungsvorrichtung verwendet werden. Derart kann das HOE z.B. die Implementierung einer Datenbrille ermöglichen, die ein Bild insbesondere von Daten erzeugt. Die Datenbrille kann als eine am Kopf zu tragenden Einrichtung (engl. "head worn device", HWD) verwendet werden. Datenbrillen sind Einrichtungen, welche wie eine herkömmliche Brille am Kopf getragen werden und zum Einen durch die Datenbrille eine Betrachtung der Umgebung ermöglichen, aber zum Anderen auch die Betrachtung eingespiegelter Daten ermöglichen. Der Begriff "Daten" ist hier allgemein zu verstehen und kann sich auf Symbole, Zeichen, Ziffern, Bildern, Videos und dergleichen beziehen. Bei anderen Einrichtungen ist nur eine Betrachtung von Daten möglich, ohne die Möglichkeit, gleichzeitig die Umgebung zu betrachten. Die Daten können kontextbezogen in Überlagerung mit der Umgebung (augmentiert) dargeboten sein und beispielsweise die Umgebungsszene ergänzende Daten, Navigationsdaten, Hinweisdaten, Benachrichtigungen, Dokumentationen, virtuelle Eingabeschnittstellen etc. betreffen.

Im Rahmen einer Datenbrille kann das HOE verschiedenste optische Funktionalitäten implementieren, z.B. insbesondere für Licht das von einer Lichtquellenanordnung der Datenbrille ausgesendet wird; z.B. wäre es möglich, dass das Brillenglas eine optische Funktionalität als lichtleitendes Element einer Bilderzeugungsvorrichtung aufweist. Hierzu kann das HOE als wellenlängenspezifischer Spiegel ausgebildet sein, der Licht eines vorbestimmten Wellenlängenbereichs modifiziert, also z.B. insbesondere in Richtung eines Beobachtungsortes hin "umlenkt" bzw. als virtuelles von dem Benutzer betrachtbares Zwischenbild abbildet, und Licht anderer Wellenlängen unverändert transmittiert. Derart kann das HOE als transflektiver Strahlvereiniger wirken, der beispielsweise das von einer Lichtquellenanordnung der Datenbrille kommende Licht eines vorbestimmten Wellenlängenbereiches zu einem Auge eines Benutzers hin umlenkt und andere Wellenlängen des Umgebungslichts als des vorbestimmten Wellenlängenbereiches unverändert transmittiert. Zusätzlich kann das HOE im Zusammenhang mit der Datenbrille optische Funktionalitäten mit weiteren optischen Wirkungsfunktionen aufweisen. Beispielsweise kann das HOE für einen definierten Winkelbereich wirken und andere Winkelbereiche unberücksichtigt lassen, also einen wellenlängenspezifischen Reflektor implementieren.

Das Brillenglas der Datenbrille kann mehrere HOEs aufweisen. Ein erstes HOE kann ausgebildet sein, von einer Lichtquellenanordnung kommendes Licht zu einem weiteren HOE zu lenken. Ein weiteres HOE kann eingerichtet sein, das in das Brillenglas eingekoppelte Licht in Richtung eines Auges eines Benutzers auszukoppeln, so dass der Benutzer unter einem bestimmten Blickwinkel ein Bild des Bildgebers beobachtet.

Als weitere Anwendung können durch das HOE Identifikations- und/oder Markenschutz-Elemente (engl. branding) implementiert werden. Z.B. könnte eine Seriennummer des Brillenglases z.B. vergleichsweise fälschungssicher durch das HOE dargestellt werden. Alternativ oder zusätzlich könnte ein Hersteller des Brillenglases durch das HOE dargestellt werden. Alternativ oder zusätzlich dazu könnte ein persönliches Identifikationsmerkmal des Brillenträgers oder der Brille identifizierbar für den Besitzer oder den Optiker durch das HOE dargestellt werden.

Mittels der voranstehend beschriebenen Techniken ist es also möglich, ein vergleichsweise weiches Material der mindestens einen HOE-fähigen Polymerschicht derart in das Brillenglas zu integrieren, dass wesentliche physikalische Eigenschaften des Brillenglases, wie zum Beispiel die optische Funktion und die mechanische Beständigkeit nicht oder nicht signifikant durch die mindestens eine HOE-fähige Polymerschicht beeinträchtigt wird - z.B. im Vergleich zu einer Referenzimplementierung ohne HOE-fähige Polymerschicht. Typischerweise weisen herkömmliche Brillengläser eine Schicht auf, die vergleichbar mit dem Substrat des Brillenglases gemäß dem gegenwärtig diskutierten Aspekt ist. Insbesondere kann es möglich sein, dass herkömmliche Brillengläser Schichten aufweisen, die ähnliche Eigenschaften aufweisen, wie die HOE-fähige Polymerschicht. Deshalb kann es möglich sein, dass die eine solche HOE-fähige Polymerschicht in ein bestehendes Schichtsystem integriert werden kann, ohne dessen optische Funktion zu beeinträchtigen.

Das Brillenglas umfasst weiterhin eine auf dem transparenten Substrat angeordnete transparente Hartschicht. Die mindestens eine HOE-fähige Polymerschicht ist zwischen dem transparenten Substrat und der Hartschicht angeordnet.

Die Hartschicht kann ein Material umfassen, welches der Hartschicht eine vergleichsweise hohe Starrheit und Festigkeit verleiht - z.B. im Vergleich zur mindestens einen HOE-fähigen Polymerschicht und dem Substrat. Dadurch kann eine besonders hohe Robustheit des Brillenglases erreicht werden. Die Hartschicht kann also thermische und mechanische Eigenschaften des Brillenglases verbessern. Z.B. kann die Hartschicht ein organisches Material umfassen. Zum Beispiel kann die Hartschicht organisch-anorganische Hybridmaterialien umfassen, z.B. auf einer Polysiloxan-Basis.

Die Hartschicht kann zur Verbesserung der Haftung einer Antireflex-Schicht bzw. einer Clean-Coat-Schicht auf dem Substrat vorgesehen sein. Optional könnte das Brillenglas auch die Antireflex-Schicht aufweisen. Alternativ oder zusätzlich könnte das Brillenglas auch die Clean-Coat-Schicht aufweisen. Beide Schichten können z.B. anorganische Materialien umfassen. Z.B. können die Antireflex-Schicht und die Clean-Coat-Schicht einen überwiegenden Anteil von anorganischen Materialien umfassen.

Z.B. können die Antireflex-Schicht und/oder die Clean-Coat-Schicht auf einer Seite des Substrats angeordnet sein, die einer Vorderseite des Brillenglases zugewendet ist. Z.B. könnte folgende Schichtfolge implementiert werden: (Rückseite): Substrat - HOE-fähige Polymerschicht - Hartschicht - Antireflex-Schicht - Clean-Coat-Schicht (Vorderseite).

Es wäre alternativ oder zusätzlich auch möglich, dass die Antireflex-Schicht und/oder die Clean-Coat-Schicht auf einer Seite des Substrats angeordnet sind, die einer Rückseite des Brillenglases zugewendet sind. Z.B. könnte folgende Schichtfolge implementiert werden: (Rückseite) Clean-Coat-Schicht - Antrireflex-Schicht - Hartschicht - Substrat - HOE-fähige Polymerschicht - Hartschicht - Antireflex-Schicht - Clean-Coat-Schicht (Vorderseite).

Zum Beispiel kann die Antireflex-Schicht mindestens zwei Materialien der folgenden Gruppe in gestapelter Anordnung umfassen: SiO₂, TiO₂, ZrO₂, Al₂O₃. Derart kann z.B. ein Interferenzschichtstapel aus oxidischen Materialien ausgebildet werden. Eine Schichtdicke der Antireflex-Schicht kann z.B. im Bereich von 200-700 nm liegen, vorzugsweise von 300-500 nm. Durch die Antireflex-Schicht kann als optische Funktionalität eine Entspieglung des Brillenglases implementiert werden; ein Reflexionswert für auf die Vorderseite des Brillenglases einfallendes Licht kann reduziert werden; alternativ oder zusätzlich kann ein Reflexionswert für auf die Rückseite des Brillenglases einfallendes Licht reduziert werden. Lichtreflexe können reduziert werden.

Die Clean-Coat-Schicht kann zur Vermeidung von Schmutzanhaftungen auf der Vorderseite oder der Rückseite des Brillenglases vorgesehen sein. Z.B. kann die Vorderseite konvex sein und/oder die Rückseite konkav sein. Eine Schichtdicke der Clean-Coat-Schicht kann im Bereich von 5-50 nm, vorzugsweise im Bereich von weniger als 10 nm liegen. Z.B. kann die Clean-Coat-Schicht kann z.B. ein Material mit hydrophoben und/oder oleophoben Eigenschaften umfassen.

Im Allgemeinen ist es auch möglich, dass das Brillenglas weiterhin die auf dem transparenten Substrat angeordnete Antireflex-Schicht umfasst. Die mindestens eine HOE-fähige Polymerschicht kann zwischen dem transparenten Substrat und der Antireflex-Schicht angeordnet sein. Insbesondere kann die Antireflex-Schicht direkt auf die HOE-fähige Polymerschicht aufgebracht werden.

Z.B. kann eine Schichtdicke jeder der mindestens einen HOE-fähigen Polymerschicht im Bereich von 1 µm - 100 µm liegen, bevorzugt im Bereich von 10 µm - 100 µm liegen. Eine solche Schichtdicke kann es erlauben, die optische Funktionalität des HOE besonders flexibel auszubilden. Es können komplexe optische Funktionalitäten implementiert werden. Es kann dadurch möglich sein, auch vergleichsweise starke optische Korrekturen vorzunehmen. Zur Implementierung optischer Funktionalitäten kann eine Schichtdicke im Bereich weniger µm ausreichen.

Es kann möglich sein, dass ein mittlerer Brechungsindex der mindestens einen HOE-fähigen Polymerschicht im Wesentlichen gleich einem Brechungsindex des transparenten Substrats und/oder der Hartschicht ist z.B. unbeschadet einer lokalen Variation des Brechungsindex aufgrund der lokalen Verkettung des Polymers in der HOE-fähigen Polymerschicht. Im Wesentlichen gleich kann hier bedeuten, dass eine Abweichung der Brechungsindizes - z.B. unter Berücksichtigung von Variationen der Schichtdicke der mindestens einen HOE-fähigen Polymerschicht - keine oder keine signifikanten Interferenzeffekte, wie z.B. Interferenzringe etc., hervorruft. Diesbezüglich kann es möglich sein, dass die HOE-fähige Polymerschicht zumindest ein Oxidmaterial wie z.B. Oxid-Nanopartikel TiO₂ und/oder ein aromatisches System und/oder Thiol-Komponenten als Additiv(e) umfasst; typischerweise kann über eine entsprechende Konzentration der Brechungsindex der HOE-fähige Polymerschicht gezielt gesteuert werden.

Zum Beispiel kann die mindestens eine HOE-fähige Polymerschicht auf einer Vorderseite des transparenten Substrats angeordnet sein. Es wäre auch möglich, dass die mindestens eine HOE-fähige Polymerschicht auf einer Rückseite des transparenten Substrats angeordnet ist.

Es wäre z.B. möglich, dass die Vorderseite konvex ist. Es wäre alternativ oder zusätzlich möglich, dass die Rückseite konkav ist. Z.B. kann es sich um ein einseitig konkaves Substrat bzw. Brillenglas handeln.

Im Allgemeinen kann das Brillenglas eine oder mehrere HOE-fähige Polymerschichten umfassen. Es wäre zum Beispiel möglich, dass eine erste HOE-fähige Polymerschicht auf der konvexen Vorderseite des transparenten Substrats angeordnet ist und eine zweite HOE-fähige Polymerschicht auf der konkaven Rückseite des transparenten Substrats angeordnet ist. Es ist möglich, dass das Brillenglas für jede HOE-fähige Polymerschicht eine oder zwei angrenze Diffusionssperrschichten umfasst.

Das Brillenglas kann weiterhin die Primer-Schicht umfassen. Die Primer-Schicht kann z.B. die Polymermatrix und/oder ein weiteres Polymer umfassen. Es ist möglich, dass die Primer-Schicht keine fotoreaktive Komponente umfasst, d.h. in Abgrenzung zur HOE-fähigen Polymerschicht, die eine fotoreaktive Komponente aufweisen kann. Es ist auch möglich, dass die Primer-Schicht nicht das HOE-Polymer umfasst. Die Primer-Schicht kann also ungeeignet sein, um das HOE auszubilden. Z.B. kann die Primer-Schicht aus einer Polymerdispersion aufgebracht werden.

Eine Schichtdicke der Primer-Schicht kann im Bereich von 0,7 - 1,0 µm liegen. Typischerweise ist das für die Primer-Schicht verwendete Material vergleichsweise weich. Daher kann die Primer-Schicht eine verbesserte Haftung der Hartschicht und der Antireflex-Schicht bzw. der Clean-Coat-Schicht auf dem Substrat bereitstellen. Außerdem kann die Primer-Schicht als belastungsdämpfende Unterlage dienen; damit können Belastungen, wie sie z.B. im Kugelfall-Schlagversuch gemäß FDA-Standard auftreten können, besser absorbiert werden.

Typischerweise ist es möglich, dass das Material der Primer-Schicht ähnlich zu dem Material der HOE-fähigen Polymerschicht ist und insbesondere ähnliche mechanische und/oder chemische Eigenschaften aufweist. Z.B. kann auch die Primer-Schicht die Polymermatrix der HOE-fähigen Polymerschicht umfassen. Es wäre aber möglich, dass die Primer-Schicht ein weiteres Polymer umfasst, welches aber z.B. ähnliche physikalische und chemische Eigenschaften wie die Polymermatrix oder das HOE-Polymer der HOE-fähigen Polymerschicht aufweisen kann. Deshalb kann es möglich sein, dass verschiedene vorteilhafte Effekte, wie sie voranstehend in Bezug auf die Primer-Schicht erläutert wurden, alternativ oder zusätzlich zu Primer-Schicht durch die HOE-fähige Polymerschicht erreicht werden können.

Voranstehend wurden in Bezug auf das Brillenglas das Substrat, die HOE-fähige Polymerschicht, die Hartschicht, die Antireflex-Schicht, die Clean-Coat-Schicht, sowie die Primer-Schicht erläutert. Es ist möglich, dass das Brillenglas weitere oder andere Schichten umfasst. Zum Beispiel können mit weiteren Schichten weitere Eigenschaften des Brillenglases realisiert bzw. verbessert werden. Zum Beispiel kann eine Schicht zur Minderung eines Wasserbeschlags vorgesehen sein. Eine solche Schicht kann hydrophil ausgebildet sein. Es wäre auch möglich, eine Schicht zur Polarisations-Filterung des einfallenden Lichts vorzusehen. Es ist auch möglich, eine Schicht mit photochromatischen Eigenschaften vorzusehen. Im Rahmen solcher vorgenannter Techniken werden typischerweise Schichten mit Schichtdicken von bis zu 100 µm verwendet. Häufig können die verwendeten Materialien solcher Schichten vergleichsweise weich ausgeprägt sein, z.B. vergleichbar mit einer Weichheit der HOE-fähigen Polymerschicht. Typischerweise können solche Schichten auf dem Polymersubstrat angeordnet sein und z.B. direkt an dieses angrenzen. Insbesondere ist es möglich, dass solche Schichten zwischen dem Substrat und der Hartschicht angeordnet sind.

Voranstehend wurden Aspekte eines Brillenglases gemäß verschiedener Ausführungsformen illustriert. Mittels entsprechender Techniken kann es möglich sein, die HOE-fähige Polymerschicht in einen Schichtstapel gemäß herkömmlicher Brillengläser zu integrieren. Dabei kann das Integrieren derart erfolgen, dass eine Funktion der üblichen Hartschicht und Antireflex-Schicht nicht oder nicht signifikant beeinträchtigt wird. Insbesondere kann es möglich sein, dass die HOE-fähige Polymerschicht mechanische Eigenschaften aufweist, die vergleichbar sind mit denen einer herkömmlichen Primer-Schicht. Daher kann es entbehrlich sein, eine Primer-Schicht bei einem Brillenglas gemäß verschiedener Ausführungsformen vorzusehen. Dies kann der Fall sein, da ein Material der HOE-fähigen Polymerschicht ähnliche chemische und mechanische Eigenschaften aufweisen kann, wie ein Material der herkömmlichen Primer-Schicht. Je nach optischem Anforderungsprofil - z.B. hinsichtlich Schichtdicke und Effizienz - kann daher die HOE-fähige Polymerschicht die Rolle der herkömmlichen Primer-Schicht ganz oder teilweise übernehmen.

Das folgende Verfahren zur Herstellung eines Brillenglases ist eine nicht zur Erfindung gehörige Variante. Das Brillenglas umfasst eine HOE-fähige Polymerschicht, die geeignet ist, um ein HOE auszubilden. Das Verfahren umfasst das Beschichten eines transparenten Substrats des Brillenglases mit einem Vorprodukt der HOE-fähigen Polymerschicht. Das Verfahren umfasst weiterhin das Umwandeln des Vorprodukts, das auf dem transparenten Substrat angeordnet ist, zum Ausbilden der HOE-fähigen Polymerschicht.

Es ist also möglich, dass die HOE-fähige Polymerschicht in-situ auf dem Substrat erzeugt wird. Das Umwandeln des Vorprodukts in die HOE-fähige Polymerschicht kann z.B. durch Erhitzen, Trocknen und/oder z.B. thermisches Aushärten erfolgen. Es können also physikalische Umwandlungsschritte eingesetzt werden. Das Vorprodukt kann z.B. die fotoreaktive Komponente umfassen. Z.B. kann das Vorprodukt das Polymer-Edukt umfassen. Das Vorprodukt kann die fotoreaktive Komponente in Form einer Dispersion oder Lösung des umfassen. Es ist möglich, dass weder das Vorprodukt noch die HOE-fähige Polymerschicht das HOE ausbilden; dazu kann ein weiterer, optionaler Belichtungsschritt erforderlich sein.

Es ist auch möglich, dass das Umwandeln eine chemische Reaktion umfasst, also reaktiv erfolgt. Z.B. kann das Umwandeln das Ausbilden der Polymermatrix aus entsprechenden Edukten umfassen, z.B. Isocyanat und Polyol. Weitere Edukte können z.B. im Rahmen des Umwandelns aufgebracht werden, z.B. lichtempfindliche Zusätze oder andere Additive. Dies kann insbesondere mit einer homogenen Schichtdicke geschehen.

Zum Beispiel kann das Vorprodukt eine polymere Trägerfolie umfassen, die die HOE-fähige Schicht beinhaltet. Solche Techniken sind z.B. aus der Druckschrift US 2010/0203241 A1 bzw. unter dem Handelsnamen Bayfol^{®} HX der Firma Bayer Material Science AG, Leverkusen, Deutschland bekannt. Hier kann z.B. eine PUR-basierte Polymermatrix zur Aufnahme lichtempfindlicher Moleküle als die fotoreaktive Komponente dienen. Dabei umfasst die fotoreaktive Komponente das HOE-ausbildende Polymer, das sich bei Belichtung umordnet und somit die für die Ausbildung von Hologrammen notwendigen Unterschiede im Brechungsindex im Bereich von 0,005 bis 0,05 ermöglichen. Das Vorprodukt ist nicht auf eine polymere Trägerfolie beschränkt; im Allgemeinen ist es möglich, dass das Vorprodukt andere oder weitere Substratmaterialien umfasst.

Das Beschichten des Substrats mit dem Vorprodukt kann z.B. Techniken der Nassbeschichtung, wie z.B. Tauch- und Schleuderbeschichtung, Aufsprühen und/oder Fluten umfassen. Alternativ oder zusätzlich kann das Beschichten Druckverfahren, wie z.B. Inkjet- und/oder Tampondruck umfassen.

Das Verfahren kann weiterhin vor dem Beschichten umfassen: Reinigen des Substrats. Z.B. kann das Reinigen mit einem geeigneten Lösungsmittel erfolgen. Das Verfahren kann weiterhin vor dem Beschichten umfassen: Aktivieren des Substrats. Z.B. kann die Aktivierung eine chemische Aktivierung mit einem geeigneten Agens umfassen und/oder eine physikalische Aktivierung z.B. über eine geeignete Plasma- oder Coronabehandlung.

Solche Techniken zum Herstellen des Brillenglases gemäß dem gegenwärtig diskutierten Aspekt könnten z.B. für mehrere HOE-fähige Polymerschichten wiederholt angewendet werden.

Voranstehend wurden Techniken illustriert, bei denen die HOE-fähige Polymerschicht in-situ auf dem Substrat des Brillenglases erzeugt werden kann. Es ist aber auch möglich, dass die HOE-fähige Polymerschicht in einem separaten Schritt hergestellt wird und anschließend auf das Substrat übertragen wird. Dies wird nachfolgend näher erläutert.

Gemäß einem Aspekt betrifft die Erfindung ein Verfahren zur Herstellung eines Brillenglases nach Patentanspruch 1. Das Brillenglas umfasst eine HOE-fähige Polymerschicht, die geeignet ist, um ein HOE auszubilden. Das Verfahren umfasst das Beschichten eines Trägers mit einem Vorprodukt der HOE-fähigen Polymerschicht. Das Verfahren umfasst weiterhin das Umwandeln des Vorprodukts, das auf dem Träger angeordnet ist, zum Erhalten der HOE-fähigen Polymerschicht. Das Verfahren umfasst weiterhin das Fixieren der HOE-fähigen Polymerschicht auf einem transparenten Substrat des Brillenglases.

In Bezug auf das Vorprodukt, das Umwandeln des Vorprodukts, das Substrat und die HOE-fähige Polymerschicht können Merkmale, die voranstehend in Bezug auf weitere Aspekte erläutert wurden, angewendet werden. Es ist also möglich, dass das Beschichten des Trägers und das Umwandeln des Vorprodukts getrennt und separat von dem Substrat erfolgt. Im Rahmen des Fixierens der HOE-fähigen Polymerschicht kann dann der Träger an das Substrat angenähert werden; das Annähern kann derart erfolgen, dass eine Seite des Trägers, auf der sich die HOE-fähige Polymerschicht befindet, dem Substrat zugewendet ist. Anschließen kann z.B. durch Aufbringen von mechanischem Druck die HOE-fähige Polymerschicht auf dem Substrat fixiert werden. Mittels solcher Techniken kann es möglich sein, die HOE-fähige Polymerschicht zu erzeugen ohne das Substrat zu beschädigen. Ferner kann der Träger besonders geeignet sein, um in den zum Umwandeln benötigten Schritten zu partizipieren. Z.B. kann der Träger eine Folie oder eine Halbschale sein.

Z.B. kann das Fixieren der HOE-fähigen Polymerschicht durch Verkleben und/oder Laminieren erfolgen. Z.B. kann das Verfahren nach dem Fixieren der HOE-fähigen Polymerschicht weiterhin das Entfernen des Trägers von der HOE-fähigen Polymerschicht umfassen. Dazu kann der Träger entsprechend vorbereitet sein. Die Vorbereitung kann z.B. darin bestehen, dass die Adhäsion gezielt eingestellt wird. so dass die Haftung zum Träger schwächer ist als zum Substrat.

Es wäre alternativ auch möglich, dass der Träger auf dem Substrat angeordnet verbleibt. Dazu kann der Träger transparent jedenfalls für sichtbares Licht ausgestaltet sein. Es wäre in einem solchen Fall möglich, dass der Träger rückseitig bereits vor Aufbringen auf dem Substrat mit einer Antireflex-Schicht und/oder einer Clean-Coat-Schicht und/oder Hartschicht und/oder einer weiteren funktionalen Schicht beschichtet ist. Der Träger kann z.B. aus demselben Material wie das transparente Substrat sein oder aus einem anderen Material gefertigt sein.

Solche Techniken zum Herstellen des Brillenglases gemäß dem gegenwärtig diskutierten Aspekt könnten z.B. für mehrere HOE-fähige Polymerschichten wiederholt angewendet werden.

Die Verfahren zur Herstellung des Brillenglases umfasst weiterhin das Aufbringen der Hartschicht, der Antireflex-Schicht und/oder der Clean-Coat-Schicht auf der HOE-fähigen Polymerschicht.

Die Hartschicht kann zur Verbesserung der Haftung der Antireflex-Schicht, der Clean-Coat-Schicht und/oder weiterer Schichten auf dem Substrat dienen. Ferner kann die Hartschicht thermische und mechanische Eigenschaften des Brillenglases verbessern. Eine Schichtdicke der Hartschicht kann z.B. 1-3 µm betragen. Typischerweise umfasst die Hartschicht organisch-anorganische Hybridmaterialien auf Polysiloxan-Basis. Es ist z.B. möglich, dass das Aufbringen der Hartschicht nasschemische Techniken umfasst. Die nasschemischen Techniken können z.B. eine Tauch- oder Schleuderbeschichtung umfassen. Zusätzlich kann das Aufbringen der Hartschicht Aushärten umfassen. Das Aushärten kann z.B. ein thermisches Aushärten durch Erwärmen und/oder eine UV-Belichtung umfassen.

Zum Aufbringen der Antireflex-Schicht kann ein Interferenzschichtstapel aus alternierenden oxidischen Materialien wie SiO₂, TiO₂, ZrO₂ oder Al₂O₃ in geeigneter Abfolge und Schichtdicke durch einen physikalischen Abscheideprozess aus der Gasphase (engl. physical vapour deposition, PVD) aufgebracht werden. Die Schichtdicke der Antireflex-Schicht kann z.B. im Bereich von 300 nm - 500 nm liegen.

Optional kann durch Einsatz ähnlicher Prozesse wie insbesondere PVD die Clean-Coat-Schicht aus entsprechenden Fluor-haltigen Vorstufen als optisch nicht wirksame oberste Schicht des Brillenglases aufgebracht werden. Die Clean-Coat-Schicht kann eine Schichtdicke von weniger als 10 nm aufweisen.

Die HOE-fähige Polymerschicht kann auf einer konvexen Vorderseite des transparenten Substrats angeordnet sein. Es ist möglich, dass die HOE-fähige Polymerschicht auf einer konkaven Rückseite des transparenten Substrats angeordnet ist. Im Rahmen einer so genannten rückseitigen Bearbeitung kann das Anordnen der HOE-fähigen Polymerschicht auf der sphärischen Vorderseite Vorteile aufweisen.

Zum Beispiel können das Vorprodukt und/oder die HOE-fähige Polymerschicht die fotoreaktive Komponente umfassen. Das Verfahren kann weiterhin das Aufbringen einer Primer-Schicht, die eine Polymermatrix und/oder ein weiteres Polymer umfasst, auf dem Substrat umfassen. Zum Beispiel kann das Aufbringen der Primer-Schicht auf Basis einer Polymerdispersion nasschemisch geschehen. Typischerweise liegt eine Schichtdicke der Primer-Schicht in einem Bereich von 0,7-1,0 µm. Durch das Aufbringen der Primer-Schicht kann die Stabilität bzw. Robustheit des Brillenglases weiter erhöht werden.

Die Verfahren zum Herstellen des Brillenglases umfassen weiterhin das ortsaufgelöste Belichten der HOE-fähigen Polymerschicht, um das HOE auszubilden. Das Belichten kann z.B. mit Schreibe-Techniken geschehen, bei denen ein oder mehrere Laserstrahlen über die Oberfläche der HOE-fähigen Polymerschicht geführt bzw. gerastert werden; hierbei können die Laserstrahlen vergleichsweise kleinflächige Strahldurchmesser aufweisen. Es können alternativ oder zusätzlich Interferenz-Techniken eingesetzt werden, bei denen mehrere vergleichsweise großflächige Laserstrahlen eingesetzt werden. Das HOE-Polymer kann durch das Belichten aus der fotoreaktiven Komponente, also z.B. dem Photomonomer bzw. Photopolymer, ausgebildet werden. Anschließend kann das zu belichtende Bild fixiert werden. Dabei können lichtempfindliche Bestandteile der HOE-fähigen Polymerschicht abreagieren und einen lichtunempfindlichen Film ausbilden. Dies betrifft z.B. eine nach dem Belichten verbliebene fotoreaktive Komponente z.B. an nicht belichteten Stellen.

Das ortsaufgelöste Belichten der HOE-fähigen Polymerschicht erfolgt nach dem Aufbringen der Hartschicht. Die Hartschicht und ggf. die Antireflex-Schicht und/oder die Clean-Coat-Schicht sind transparent für das für das Belichten eingesetzte Licht und verursachen keine oder keine signifikanten optischen Störeffekte. Dabei kann zur Reduzierung oder Vermeidung von Rückseitenreflexen eine Schwärzung der Rückseite (engl. black backing) verwendet werden.

In dem obenstehend beschriebenen Fall, bei dem das Belichten nach dem Aufbringen der Hartschicht und ggf. der Antireflex-Schicht und der Clean-Coat-Schicht erfolgt, kann es möglich sein, ein vorgefertigtes Brillenglas mit allen Schichten eines entsprechenden Schichtstapels vorzuhalten bzw. zu lagern. Anschließend kann das Belichten zum Ausbilden des HOE erfolgen. Dies kann insbesondere eine einfachere und schnellere Herstellung des Brillenglases mit integriertem HOE ermöglichen.

Obenstehend wurde ein Szenario beschrieben, in dem das Umwandeln des Vorprodukts zum Erhalten der HOE-fähigen Polymerschicht auf einem Träger geschieht, wobei anschließend die HOE-fähige Polymerschicht auf dem transparenten Substrat des Brillenglases fixiert wird. Insbesondere in einem solchen Szenario ist es möglich, dass das ortsaufgelöste Belichten der HOE-fähigen Polymerschicht vor dem Fixieren der HOE-fähigen Polymerschicht auf dem transparenten Substrat erfolgt. In anderen Worten kann das HOE bereits auf dem Träger, z.B. einer Folie, ausgebildet und dann die belichtete HOE-fähige Polymerschicht, die bereits das HOE ausbildet, auf dem Substrat fixiert werden. Das Fixieren kann durch Laminieren und/oder Verkleben geschehen. In einem solchen Fall kann es erstrebenswert sein, eine Stauchung / Zerrung des HOE durch die Geometrie einer Oberfläche des Substrats bereits bei dem Belichten zu berücksichtigen. Das ortsaufgelöste Belichten umfasst das Erhalten von Geometriedaten, welche eine Geometrie des Substrats des Brillenglases beschreiben. Das ortsaufgelöste Belichten umfasst weiterhin in Abhängigkeit der Geometriedaten das Bestimmen von Steuerdaten.

Die Steuerdaten beschreiben eine Intensität und Phase des ortsaufgelösten Belichtens beschreiben. Das ortsaufgelöste Belichten erfolgt mit den Steuerdaten. Mittels solcher Techniken kann erreicht werden, dass das Belichten in einem separaten Prozess auf dem Träger erfolgen kann. Auch black backing kann einfacher zu realisieren sein.

Voranstehend wurden verschiedene Techniken zur Herstellung des Brillenglases, das die HOE-fähige Polymerschicht umfasst, erläutert. Im Allgemeinen können die voranstehend beschriebenen Techniken bei der Rezeptglasfertigung auf einem bearbeiteten Rezeptglas bzw. Fertigglas erfolgen. Es wäre aber auch möglich, dass die voranstehend beschriebenen Techniken in Bezug auf ein Halbfabrikat-Glas erfolgen, aus dem erst in einem späteren Schritt ein Rezeptglas erzeugt wird. In dem letztgenannten Fall kann es vorteilhaft sein, die HOE-fähige Polymerschicht mit der Hartschicht vor Schäden in der nachfolgenden Rezeptglasfertigung zu schützen. Eine Bearbeitung bei der Rezeptglasfertigung sollte in einem solchen Fall auf derjenigen Seite des Brillenglases erfolgen, die nicht durch die HOE-fähige Polymerschicht beschichtet ist.

Die oben dargelegten Merkmale und Merkmale, die nachfolgend beschrieben werden, können nicht nur in den entsprechenden explizit dargelegten Kombinationen verwendet werden, sondern auch in weiteren Kombinationen oder isoliert, ohne den Schutzumfang der vorliegenden Erfindung zu verlassen.

### KURZE BESCHREIBUNG DER FIGUREN

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die im Zusammenhang mit den Zeichnungen näher erläutert werden.
FIG. 1 ist eine schematische Explosionszeichnung eines Brillenglases mit verschiedenen Schichten.
FIG. 2 ist ein Flussdiagramm eines Verfahrens zur Herstellung eines Brillenglases in einer nicht zur Erfindung gehörigen Variante, wobei bei dem Verfahren eine HOE-fähige Polymerschicht, die geeignet ist, um ein HOE auszubilden, auf einem separaten Träger erzeugt wird.
FIG. 3 ist ein Flussdiagramm eines Verfahrens zur Herstellung eines Brillenglases in einer nicht zur Erfindung gehörigen Variante, wobei bei dem Verfahren die HOE-fähige Polymerschicht, die geeignet ist, um das HOE auszubilden, in-situ auf einem Substrat des Brillenglases erzeugt wird.
FIGs. 4 - 6 illustrieren Verfahrensschritte des Verfahrens der FIG. 2 anhand schematischer Zeichnungen verschiedener Fertigungsstufen des Brillenglases.
FIGs. 7 - 10 illustrieren Verfahrensschritte der Verfahren gemäß FIGs. 2 und 3 in einer nicht zur Erfindung gehörigen Variante anhand schematischer Zeichnungen verschiedener Fertigungsstufen des Brillenglases.
FIGs. 11 - 14 illustrieren Verfahrensschritte der Verfahren gemäß FIGs. 2 und 3 in einer nicht zur Erfindung gehörenden Variante anhand schematischer Zeichnungen verschiedener Fertigungsstufen des Brillenglases.
FIG. 15 ist eine schematische Explosionszeichnung eines Brillenglases mit verschiedenen Schichten.
FIG. 16 ist eine schematische Explosionszeichnung eines Brillenglases mit verschiedenen Schichten.
FIG. 17 ist eine schematische Seitenansicht einer Datenbrille mit einem HOE.
FIG. 18 ist eine schematische Seitenansicht einer Datenbrille mit einem HOE.

### DETAILLIERTE BESCHREIBUNG VON AUSFÜHRUNGSBEISPIELEN

Nachfolgend wird die vorliegende Erfindung anhand bevorzugter Ausführungsformen unter Bezugnahme auf die Zeichnungen näher erläutert. In den Figuren bezeichnen gleiche Bezugszeichen gleiche oder ähnliche Elemente. Die Figuren sind schematische Darstellungen verschiedener Ausführungsformen der Erfindung. In den Figuren dargestellte Elemente sind nicht notwendigerweise maßstabsgetreu dargestellt. Vielmehr sind die verschiedenen in den Figuren dargestellten Elemente derart wiedergegeben, dass ihre Funktion und ihr Zweck dem Fachmann verständlich werden.

Nachfolgend werden Techniken im Zusammenhang mit dem Bereitstellen eines HOE-fähigen Materials in einem Brillenglas erläutert.

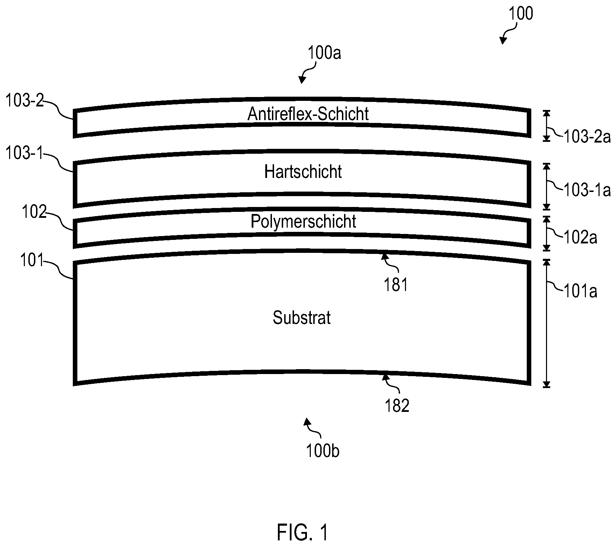

In FIG. 1 ist ein Brillenglas 100 gemäß verschiedener Ausführungsformen in einer Explosions-Schemazeichnung gezeigt. Das Brillenglas kann z.B. in einer Brille verwendet werden, etwa einer Datenbrille (in FIG. 1 nicht gezeigt). Das Brillenglas 100 umfasst ein Substrat 101. Eine Mittendicke 101a des Substrats 101 beträgt typischerweise ca. 1-3 mm. Das Substrat ist transparent für Licht im sichtbaren Wellenlängenbereich.

Angrenzend an das Substrat 101 ist eine HOE-fähige Polymerschicht 102 angeordnet. Die HOE-fähige Polymerschicht 102 ist geeignet, um das HOE auszubilden. Die HOE-fähige Polymerschicht 102 umfasst z.B. ein HOE-Polymer oder eine fotoreaktive Komponente, die ein Polymer-Edukt des HOE-Polymers umfasst. Durch lokale Polymerisations- und/oder Diffusionsprozesse des Polymer-Edukts kann das HOE-Polymer ausgebildet werden, wodurch es wiederum zu einer lokalen Variation des Brechungsindex kommen kann. Dadurch kann eine optische Funktionalität des Brillenglases 100 implementiert werden. Das HOE-Polymer bzw. die fotoreaktive Komponente können z.B. in einer PUR-basierten Polymermatrix eingebettet sein. Z.B. könnte angrenzend an die Polymerschicht 102 weiterhin eine oder zwei Diffusionssperrschicht(en) vorgesehen sein (in FIG. 1 nicht gezeigt).

In FIG. 1 ist weiterhin eine Schichtdicke 102a der HOE-fähigen Polymerschicht 102 illustriert. Die Schichtdicke 102a der HOE-fähigen Polymerschicht liegt in einem Bereich von 1 µm bis 100 µm, bevorzugt in einem Bereich von 50 µm bis 100 µm. Typischerweise kann eine Beeinflussung der optischen Eigenschaften des Brillenglases 100 durch das HOE umso größer sein, je größer die Schichtdicke 102a der HOE-fähigen Polymerschicht 102 ist. Mittels größeren Schichtdicken 102a können komplexere optische Funktionalitäten implementiert werden, d.h. z.B. kann ein Strahlengang des Lichts durch das HOE stärker verändert werden.

Das Brillenglas 100 der FIG. 1 umfasst ein Schichtpaket, das weiterhin eine Hartschicht 103-1 und eine Antireflex-Schicht 103-2 umfasst. Eine Schichtdicke 103-1a der Hartschicht 103-1 liegt in einem Bereich von 1 µm bis 3 µm. Eine Schichtdicke 103-2a der Antireflex-Schicht 103-2 liegt in einem Bereich von etwa 300 bis 500 nm. Zum Beispiel weist die Antireflex-Schicht 103-2 einen Interferenzschichtstapel aus oxidischen Materialien wie SiO₂, TiO₂, ZrO₂ und Al₂O₃ in geeigneter Abfolge und Schichtdicke auf.

Alternativ oder zusätzlich könnte eine Antireflex-Schicht an einer Rückseite 100b des Brillenglases 100 vorgesehen sein.

Optional könnte das Brillenglas 100 z.B. eine Clean-Coat-Schicht umfassen (in FIG. 1 nicht gezeigt). Die Clean-Coat-Schicht kann z.B. angrenzen an die Antireflex-Schicht 103-2 einen Abschluss des Brillenglases 100 auf dessen Vorderseite 100a ausbilden. Die Clean-Coat-Schicht kann z.B. eine Schichtdicke im Bereich von 5 nm - 50 nm aufweisen.

In FIG. 1 ist ein Szenario gezeigt, bei dem die HOE-fähige Polymerschicht 102 auf einer konvexen Vorderseite 181 des Substrats 101 angeordnet ist, die der Vorderseite 100a des Brillenglases 100 zugewendet ist. Es wäre aber auch möglich, dass die HOE-fähige Polymerschicht 102 auf einer konkaven Rückseite 182 des Substrats 101 angeordnet ist, die der Rückseite 100b des Brillenglases 100 zugewendet ist.

In der FIG. 1 ist ein Szenario gezeigt, bei dem das Brillenglas 100 eine einzelne HOE-fähige Polymerschicht 102 umfasst. Es wäre aber auch möglich, dass das Brillenglas 100 mehr als eine HOE-fähige Polymerschicht 102 umfasst. Zum Beispiel könnte das Brillenglas 100 eine erste HOE-fähige Polymerschicht 102 auf der konvexen Vorderseite 181 des transparenten Substrats 101 umfassen und eine zweite HOE-fähige Polymerschicht auf der konkaven Rückseite 182 des transparenten Substrats 101 umfassen (in FIG. 1 nicht gezeigt).

Durch eine Kombination mehrerer HOE-fähiger Polymerschichten 102, die z.B. verschiedene HOEs ausbilden, können auch spezielle optische Funktionalitäten durch ein kohärentes oder inkohärentes Zusammenwirken der verschiedenen HOEs erreicht werden. Dies kann z.B. im Zusammenhang mit dem Implementieren einer Datenbrille erstrebenswert sein. Beispiele hierfür wären Anordnungen nach dem Aktuator-Kompensator-Prinzip, siehe deutsche Patentanmeldung mit der Annmeldenummer 102014209792.4. Ein weiteres Beispiel für die Anordnung wäre ein Mehrlagensystem, das mehrere HOE-fähige Polymerschichten, die unterschiedliche HOEs ausbilden, denkbar, welches für so genanntes Winkelmultiplexing eingesetzt wird. Hierbei ist die optische Funktionalität, z.B. die Fokussierung, eines einzelnen HOEs auf einen engen Blickwinkelbereich des Brillenträgers beschränkt, während die übrigen Blickwinkelbereiche durch dieses HOE unbenommen sind. Jede Schicht des Mehrlagensystems kann in einem solchen Szenario ein weiteres HOE enthalten, das für einen anderen Blickwinkelbereich optisch funktional ist. Die HOEs wirken voneinander unabhängig, so dass jedes eine unabhängige optische Funktion für einen definierten Blickwinkelbereich darstellt. Zusammen wirken sie optisch für den gesamten Blickwinkelbereich.

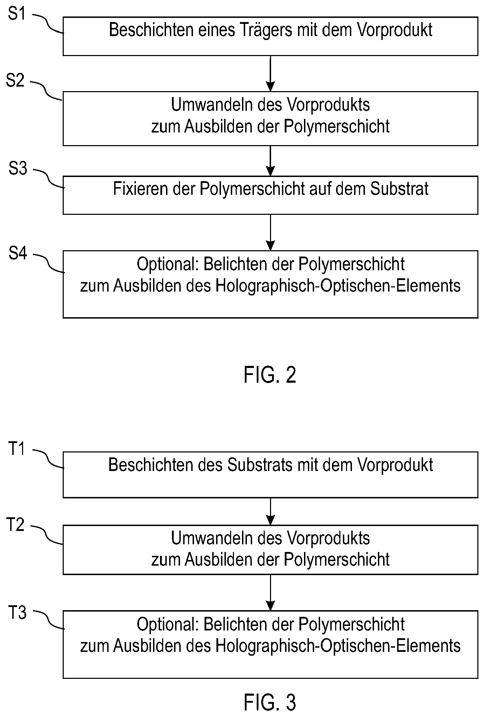

In der FIG. 2 ist ein Flussdiagramm eines Verfahrens zur Herstellung eines Brillenglases 100 gemäß verschiedener Ausführungsformen gezeigt. Dabei erfolgt das Ausbilden der HOE-fähigen Polymerschicht 102 nicht in-situ auf dem Substrat 101, sondern getrennt auf einem separaten Träger.

Zunächst erfolgt in Schritt S1 das Beschichten des Trägers mit einem Vorprodukt der HOE-fähigen Polymerschicht 102. Dabei kann das Vorprodukt der HOE-fähigen Polymerschicht 102 z.B. flüssig oder fest sein; das Vorprodukt kann z.B. in Folienform bereitgestellt werden. Das Vorprodukt der HOE-fähigen Polymerschicht 102 kann noch nicht oder nur eingeschränkt geeignet sein, um das HOE auszubilden. Z.B. kann das Vorprodukt eine spezielle Formulierung der Polymere, die geeignet sind, die Polymermatrix auszubilden, umfassen; es wäre auch möglich, dass das Vorprodukt Edukte der Polymere, die geeignet sind, die Polymermatrix auszubilden, umfasst, je nachdem ob in Schritt S2 ein reaktives Umwandeln erfolgt oder nicht. Das Vorprodukt kann z.B. weitere Additive umfassen, wie z.B. einen Katalysator, ein Fließhilfsmittel etc., die zum Ausbilden der Polymermatrix benötigt werden. Das Vorprodukt kann z.B. fotoreaktive Komponenten enthalten, die z.B. Monomere, Initiatoren, und/oder Farbstoffe, etc. umfassen können.

In Schritt S2 erfolgt das Umwandeln des Vorprodukts zum Ausbilden der HOE-fähigen Polymerschicht 102. In Schritt S2 kann z.B. ein thermisches Aushärten des Vorprodukts zum Ausbilden eines stabilen Films als die HOE-fähige Polymerschicht 102 erfolgen; z.B. kann die Formulierung durch Verdampfen des Lösungsmittels in einen festen Film umgewandelt werden, z.B. durch Ausbilden der Polymermatrix. Alternativ oder zusätzlich können in Schritt S2 auch reaktive Prozessschritte durchgeführt werden, die eine chemische Reaktion beinhalten. Z.B. kann in Schritt S2 die Polymermatrix durch geeignete Reaktion einzelner Moleküle ausgebildet werden. Zum Beispiel können in Schritt S2 weitere Additive und/oder lichtempfindliche Zusätze zu dem Vorprodukt zugegeben werden.

In Schritt S3 erfolgt das Fixieren der HOE-fähigen Polymerschicht 102 auf dem Substrat 101. Dies erfolgt typischerweise durch Verkleben und/oder Laminieren der HOE-fähigen Polymerschicht 102 auf dem Substrat. Es wäre möglich, dass anschließend der Träger vom Brillenglas 100 entfernt wird. Es ist aber auch möglich, dass der Träger auf der HOE-fähigen Polymerschicht 102 verbleibt.

In Schritt S4 erfolgt das Belichten der HOE-fähigen Polymerschicht 102 zum Ausbilden des HOE. Schritt S4 ist ein optionaler Schritt; Schritt S4 sollte jedoch durchgeführt werden, sofern das HOE tatsächlich ausgebildet werden soll. In Schritt S4 erfolgt das Umwandeln des Polymer-Edukts in das HOE-Polymer; dabei erfolgt eine reaktive Umwandlung der fotoreaktiven Komponente, z.B. eines Photomonomers oder eines Photopolymers, unter Polymerisation und/oder Diffusion. Dieser Prozess resultiert in einer örtlich wohldefinierten Variation des Brechungsindex in der Polymerschicht, wodurch optische Merkmale in Form des HOE implementiert werden können.

In FIG. 3 ist ein Flussdiagramm eines weiteren Verfahrens zur Herstellung eines Brillenglases 100 gemäß verschiedener Ausführungsformen gezeigt. Dabei erfolgt das Ausbilden der HOE-fähigen Polymerschicht 102 in-situ auf dem Substrat 101. Zunächst wird das Substrat 101 in Schritt T1 mit dem Vorprodukt beschichtet.

In Schritt T2 erfolgt das Umwandeln des Vorprodukts zum Ausbilden der HOE-fähigen Polymerschicht 102. Schritt T2 kann entsprechend Schritt S1 der FIG. 2 durchgeführt werden.

In Schritt T3 erfolgt das Belichten der HOE-fähigen Polymerschicht 102 zum Ausbilden des HOE. Schritt T3 ist ein optionaler Schritt; Schritt T3 muss ausgeführt werden, sofern das HOE tatsächlich ausgebildet werden soll. Schritt T3 kann entsprechend Schritt S4 der FIG. 2 ausgeführt werden.

Sowohl in Bezug auf den Schritt S3 der FIG. 2, als auch in Bezug auf den Schritt T1 der FIG. 3 kann es erstrebenswert sein, die entsprechende Oberfläche 181, 182 des Substrats 101 vor dem Aufbringen der HOE-fähigen Polymerschicht 102 bzw. des Vorprodukts der HOE-fähigen Polymerschicht 102 vorzubehandeln. Zum Beispiel kann eine Reinigung der entsprechenden Oberfläche 181, 182 des Substrats 101 erfolgen. Alternativ oder zusätzlich kann eine Aktivierung der entsprechenden Oberfläche 181, 182 des Substrats 101 erfolgen.

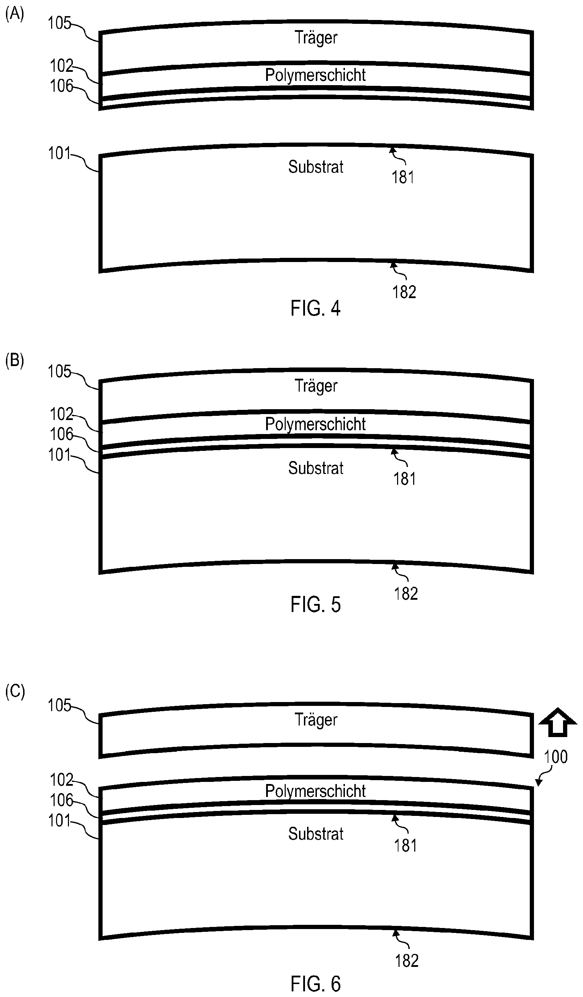

FIGs. 4 - 6 zeigen schematisch verschiedene Fertigungsstufen bzw. Fertigungsstücke des Brillenglases 100 gemäß dem Verfahren nach FIG. 2. In FIG. 4 - einem Zustand A - befindet sich die HOE-fähige Polymerschicht 102 auf dem Träger 105. Z.B. kann der Träger 105 eine Folie oder eine Halbschale umfassen. Die Halbschale kann z.B. konkav oder konvex ausgestaltet sein. Der Träger 105 kann komplementär zur Vorderseite 181 des Substrats 101 geformt sein. Angrenzend an die HOE-fähige Polymerschicht 102 ist weiterhin eine Klebe- /Laminatbeschichtung 106 auf dem Träger 105 angeordnet. Alternativ oder zusätzlich zur Klebe- /Laminatbeschichtung 106 können auch Techniken des Lösungsmittelverklebens eingesetzt werden.

In FIG. 5 ist ein Zustand B gezeigt, bei dem der Träger 105, die HOE-fähige Polymerschicht 102 und die Klebe-/Laminatbeschichtung 106 in Kontakt mit dem Substrat 101 gebracht sind. Insbesondere ist die Klebe-/Laminatbeschichtung 106 in Kontakt mit der Vorderseite 181 des Substrats 101. Es wäre alternativ oder zusätzlich auch möglich, die HOE-fähige Polymerschicht 102 an der Rückseite 182 des Substrats 101 anzubringen.

In FIG. 6 ist ein Zustand C gezeigt, bei dem der Träger 105 von der HOE-fähigen Polymerschicht 102 abgelöst ist und von dieser entfernt wird (in FIG. 6 durch den vertikalen Pfeil illustriert). Alternativ wäre es auch möglich, dass der Träger 105 auf der HOE-fähigen Polymerschicht 102 verbleibt. In dem letztgenannten Fall kann es z.B. möglich sein, dass die Hartschicht und/oder die Antireflex-Schicht (beide in FIG. 6 nicht gezeigt) auf der äußeren Oberfläche des Trägers 105 ausgebildet werden.

Damit ist der Zustand C im Herstellungsprozess des Brillenglases 100 erreicht, bei dem die HOE-fähige Polymerschicht 102 auf dem Substrat 101 angeordnet ist. Anschließend kann das Beschichten mit der Hartschicht 103-1 und/oder der Antireflex-Schicht 103-2 und/oder der Clean-Coat-Schicht erfolgen (in FIGs. 4 - 6 nicht gezeigt). Im Allgemeinen ist es auch möglich, dass die Hartschicht (in FIGs. 4 - 6 nicht gezeigt) bereits mit der HOE-fähigen Polymerschicht 102 aufgebracht/auflaminiert wird

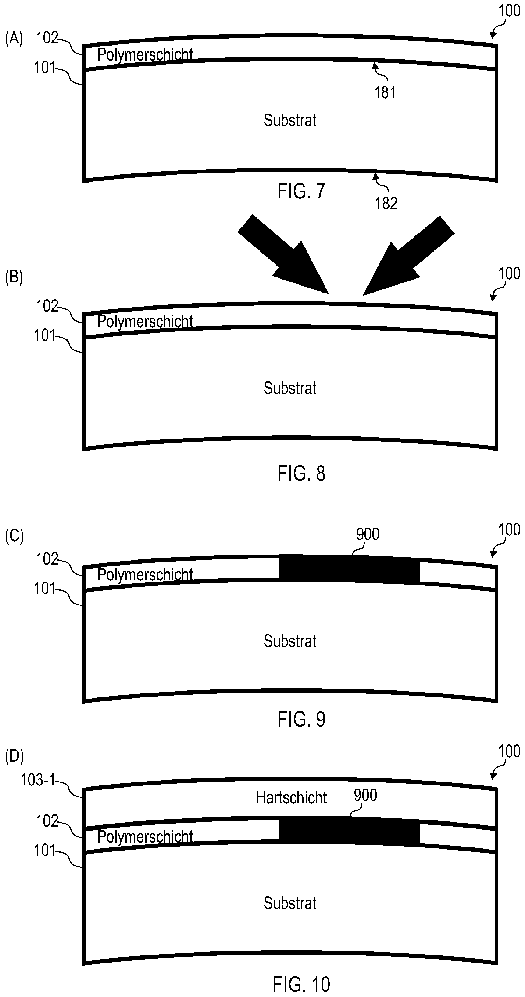

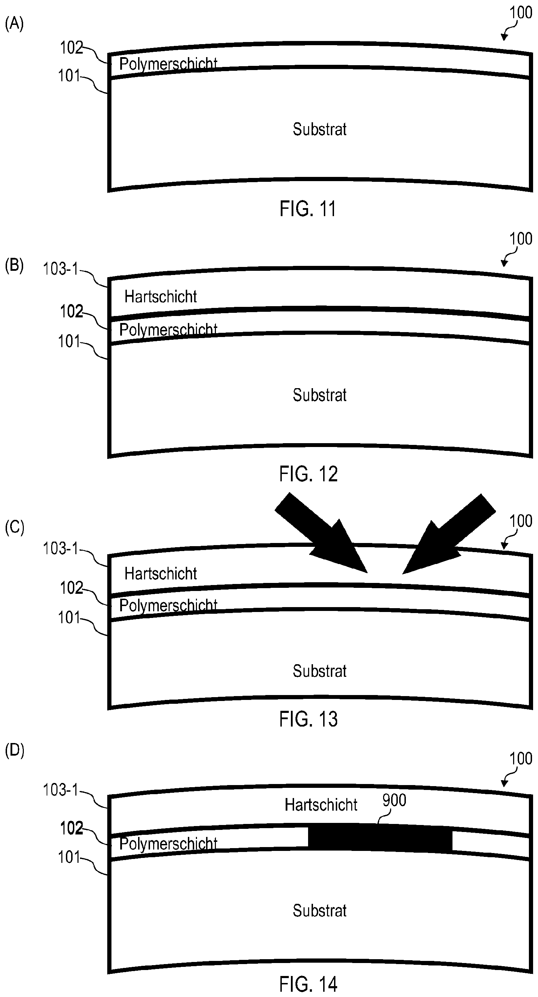

In den FIGs. 7 - 10 (die nicht zur Erfindung gehören), sowie den FIGs. 11 - 14 (die nicht zur

Erfindung gehören) sind verschiedene Szenarien für das Belichten der HOE-fähigen Polymerschicht 102 zum Ausbilden des HOE dargestellt. Dabei ist zunächst in FIG. 7 ein Zustand A gezeigt, bei dem die HOE-fähige Polymerschicht 102 auf dem Substrat 101 angeordnet ist. Z.B. könnte eine Klebe-/Laminatschicht (in FIG. 7 nicht gezeigt) die HOE-fähige Polymerschicht 102 angrenzend an die Vorderseite 181 des Substrats 101 fixieren. Die HOE-fähige Polymerschicht 102 ist geeignet, um das HOE auszubilden; dazu umfasst die HOE-fähige Polymerschicht 102 eine geeignete fotoreaktive Komponente, die z.B. das Photomonomer umfasst. Eine Reaktion dieser fotoreaktiven Komponente der Polymerschicht hat in FIG. 7 noch nicht stattgefunden. Die HOE-fähige Polymerschicht 102 umfasst die Polymermatrix.

In FIG. 8 ist ein Zustand B während des Belichtens der HOE-fähigen Polymerschicht 102 dargestellt. Das Belichten erfolgt ortsaufgelöst und phasenkohärent mit wohldefinierter Phase und Intensität (in FIG. 8 durch die zwei gefüllten Pfeile dargestellt). Dadurch wird das HOE 900 ausgebildet (cf. FIG. 9). In der FIG. 9 ist ein Zustand C gezeigt, in dem das HOE 900 Identifizierungs- oder Branding-Funktion aufweist. Deshalb ist es ausreichend, dass sich das HOE 900 nur über einen Teilbereich der gesamten Fläche der HOE-fähigen Polymerschicht 102 erstreckt.

Es wäre aber auch möglich, dass das Belichten derart erfolgt, das HOE 900 die optischen Funktionalitäten des Brillenglases 100 betreffend Sehfehler des Auges des Brillenträgers verändert. Insbesondere in einem solchen Fall kann es erstrebenswert sein, wenn sich das HOE 900 im Wesentlichen über die gesamte Fläche der HOE-fähigen Polymerschicht 102 erstreckt (in FIG. 9 nicht gezeigt). Derart kann es möglich sein, eine entsprechende optische Funktionalität homogen im Bereich des Brillenglases 101 zu implementieren.

Im Zustand D der FIG. 10 ist die HOE-fähige Polymerschicht 102, die nunmehr das HOE 900 ausbildet, mit der Hartschicht 103-1 beschichtet. Optional könnte eine Beschichtung mit der Antireflex-Schicht 103-2 und/oder der Clean-Coat-Schicht erfolgen (in FIG. 10 nicht gezeigt). In den FIGs. 11 - 14 sind erfindungsgemäße Techniken, die das Belichten der HOE-fähigen Polymerschicht 102 zum Ausbilden des HOEs 900 betreffen, dargestellt. Bei diesen Techniken wird die HOE-fähige Polymerschicht 102 nach dem Aufbringen der Hartschicht 103-1 belichtet.

Im Zustand A der FIG. 11 ist die HOE-fähige Polymerschicht 102 auf dem Substrat 101 ausgebildet. In FIG. 12 ist ein Zustand dargestellt, bei dem die Hartschicht 103-1 auf dem Substrat 101 angeordnet ist, wobei sich zwischen der Hartschicht 103-1 und dem Substrat 101 die HOE-fähige Polymerschicht 102 befindet. Die HOE-fähige Polymerschicht 102 ist geeignet, um ein HOE 900 auszubilden. Das HOE 900 ist im Zustand der FIG. 12 aber noch nicht ausgebildet.

In FIG. 13 ist ein Zustand C während dem Belichten der HOE-fähigen Polymerschicht 102 dargestellt. Das Belichten erfolgt durch die Hartschicht 103-1 hindurch, wobei die Hartschicht 103-1 transparent für eine verwendete Wellenlänge des Lichts der Belichtung ist. Es wäre optional auch möglich, dass im Zustand C der FIG. 13 auch eine Antireflex-Schicht auf der Hartschicht 103-1 angeordnet ist (in FIG. 13 nicht gezeigt). Dann könnte das Belichten auch durch die Antireflex-Schicht hindurch erfolgen. Dabei kann eine besonders hohe Effizienz des Belichtens erreicht werden, da Reflexionsverluste möglicherweise reduziert werden können.

Im Zustand D der FIG. 14 ist das HOE 900 ausgebildet. Es kann dann noch ein Fixieren bzw. Bleichen zur Deaktivierung von bei der Belichtung nicht belichteter Bereiche erfolgen. Derart kann eine nachträgliche Veränderung, Abschwächung oder Zerstörung des HOE 900 verhindert werden. Dies wird häufig auch als Fixierung des HOE 900 bezeichnet.

Techniken gem. FIGs. 11 - 14 weisen den Vorteil auf, dass das fertige Brillenglas 100, z.B. im Zustand B gem. FIG. 12, gelagert werden kann und erst zu einem späteren Zeitpunkt das Belichten zum Ausbilden des HOEs 900 erfolgt. Dies kann es ermöglichen, dass fertige Brillenglas 100 mit ausgebildetem HOE 900 besonders schnell herzustellen.

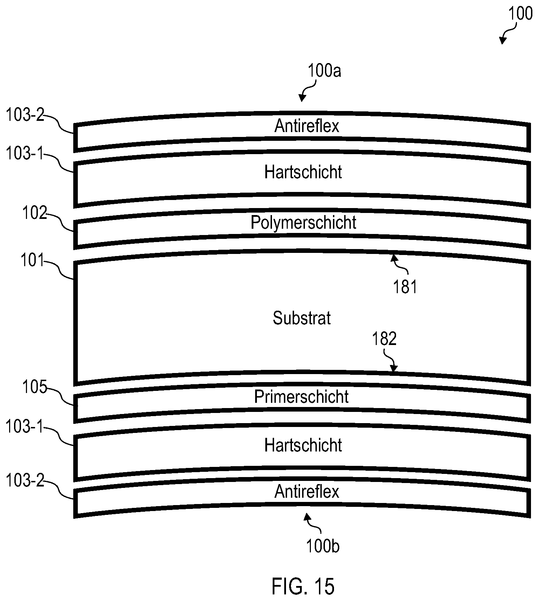

In FIG. 15 ist ein Brillenglas 100 in einer schematischen Explosionsdarstellung illustriert. Das Brillenglas 100 in FIG. 15 weist zwei Hartschichten 103-1 und zwei Antireflex-Schichten 103-2 auf. Auf der Rückseite 182 des Substrats 101 ist eine Primer-Schicht 105 angeordnet. Die Primer-Schicht 105 ist optional. Durch die Primer-Schicht 105 kann eine Verstärkung des Brillenglases 100 erreicht werden. Außerdem kann eine verbesserte Haftung der rückseitig angeordneten Hartschicht 103-1 und der Antireflex-Schicht 103-2 auf dem Substrat 101 erreicht werden; dies ist vergleichbar mit dem Effekt, der in Bezug auf die vorderseitig angeordnete Hartschicht 1003-1 und Antireflex-Schicht 103-2 durch die Polymerschicht 102 erzielt werden kann.

Es wäre in dem Szenario der FIG. 15 z.B. auch möglich, dass - zusätzlich zu der Primer-Schicht 102 - eine weitere Primer-Schicht auf der Vorderseite 181 des Substrats 101 angeordnet ist (in FIG. 15 nicht gezeigt). Z.B. könnte(n) die Primer-Schicht(en) mittels Techniken der Tauchbeschichtung aufgebracht sein.

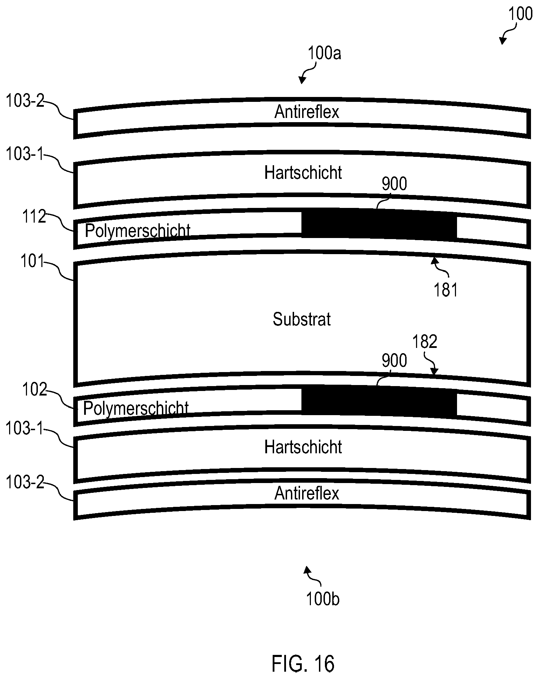

Bezug nehmend auf FIG. 16: anstelle der Primer-Schicht 105 könnte auch eine weitere HOE-fähige Polymerschicht 112 vorgesehen sein werden. In dem Szenario der FIG. 16 wirken die HOEs 900 zusammen, um eine optische Funktionalität zu implementieren.

Voranstehend wurden Techniken zum Bereitstellen einer HOE-fähige Polymerschicht 102, die geeignet ist, um ein HOE 900 auszubilden, in einem Brillenglas 100 illustriert. Solche Techniken weisen verschiedene Effekte und Vorteile auf. Zum Beispiel ist es möglich, die HOE-fähige Polymerschicht 102, die geeignet ist, um das HOE 900 auszubilden, in das Brillenglas 100 unter Beibehaltung des Schichtaufbaus eines herkömmlichen Brillenglas 100 zu integrieren. Insbesondere ist es möglich, dass eine Bruch-stabilisierende Wirkung der Primer-Schicht 105 durch die HOE-fähige Polymerschicht 102 erreicht wird. Daher kann entbehrlich sein, die Primer-Schicht 105 vorzusehen. Bestimmte Belastungen, die z.B. im Rahmen des Kugelfall-Schlagversuchs gemäß FDA-Standard auftreten können, können dadurch besser überstanden werden. Typischerweise kann das HOE-Polymer bzw. Polymer-Edukt oder eine Polymermatrix, das in der HOE-fähigen Polymerschicht 102 verwendet wird, ähnlich zu einem Polymer sein, dass in der Primer-Schicht 105 verwendet wird. Deshalb kann es möglich sein, dass eine entsprechende Polymerchemie wie sie z.B. in Bezug auf die Primer-Schicht 105 bekannt ist, auch für die Behandlung der HOE-fähigen Polymerschicht 102 verwendet wird. Insbesondere kann eine gute Adhäsion des Polymers der HOE-fähigen Polymerschicht 102 auf dem Substrat 101 erreicht werden. Dazu kann das Substrat 101 z.B. gereinigt und/oder aktiviert werden. Ferner kann eine gute Adhäsion der Hartschicht 103-1 auf der HOE-fähigen Polymerschicht 102 sichergestellt werden. Dadurch kann insgesamt eine gute Beständigkeit und Haltbarkeit des Brillenglases 101 gewährleistet werden. Ferner besteht gemäß der voranstehend beschriebenen Techniken die Möglichkeit der Ausstattung von Halbfabrikats-Gläsern bzw. Fertig-Gläsern, die bereits die Hartschicht 103-1 und gegebenenfalls die Antireflex-Schicht 103-2 und/oder die Clean-Coat-Schicht umfassen, mit der HOE-fähigen Polymerschicht 102. Eine Belichtung der HOE-fähigen Polymerschicht 102 zum Ausbilden des HOEs 900 kann bedarfsorientiert und individuell erfolgen, z.B. um Kundendaten und/oder angepasste optische Korrekturen vorzusehen. Mittels der voranstehend beschriebenen Techniken ist es auch möglich, dass das HOE 900 in der gesamten Fläche des Brillenglases 100 ausgebildet wird. Dabei kann eine optische Funktionalität, die durch das HOE 900 implementiert wird, vergleichsweise wenig limitiert sein. Insbesondere kann es möglich sein, auch komplexere optische Funktionalitäten, die z.B. über eine reine Identifizierungs-/Branding-Funktion hinaus gehen, zu implementieren. Mittels der voranstehend beschriebenen Techniken ist es auch möglich, mehr als eine HOE-fähige Polymerschicht 102 in das Brillenglas 100 zu integrieren. Insbesondere kann es möglich sein, mehrere Polymerschichten 102, 112 auf unterschiedlichen Seiten 181,182 des Substrats 101 anzuordnen. Dadurch können komplexe optische Funktionalitäten durch die verschiedenen HOEs 900 der verschiedenen Polymerschichten 102, 112 erzielt werden.

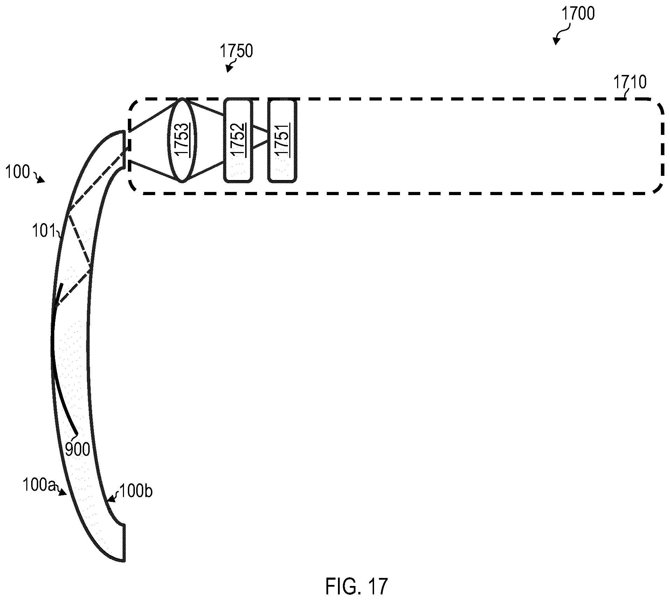

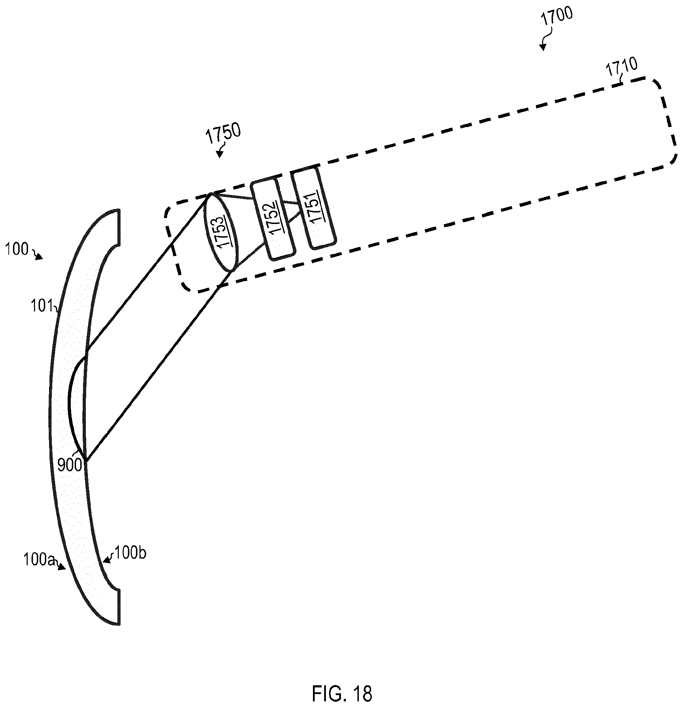

In FIGs. 17 und 18 sind Aspekte des HOEs 900, das im Zusammenhang mit einer Datenbrille 1700 verwendet wird, illustriert. Das HOE 900 reflektiert Licht, das von einer Lichtquellenanordnung 1750 der Datenbrille 1700 ausgesendet wird. Dabei implementiert das HOE 900 z.B. die optische Funktionalität eines wellenlängenspezifischen Spiegels; es wäre alternativ oder zusätzlich auch möglich, dass das HOE 900 die optische Funktionalität eines winkelspezifischen Reflektors und/oder eines transflektiven Strahlvereinigers implementiert. Diesbezüglich weist das HOE 900 also Abbildungsfunktionalität auf.

Obwohl in FIGs. 17 und 18 jeweils nur ein einzelnes HOE 900 dargestellt ist, könnten die verschiedenen optischen Funktionalitäten, die im Zusammenhang mit der Datenbrille 1700 durch Verwendung der Techniken der Holografie implementiert werden, auch durch zwei oder mehr HOEs 900, die optisch zusammenwirken, implementiert werden.

Aus Gründen der Übersichtlichkeit sind in den FIGs. 17 und 18 weiterhin lediglich das Substrat 101 und das HOE 900 illustriert; das Brillenglas 100 kann aber eine Anordnung und eine Anzahl von Elementen, wie voranstehend diskutiert, aufweisen.

Im Detail umfasst die Datenbrille 1700 einen Bügel 1710. Der Bügel 1710 weist ein Gehäuse auf, in welchem die Lichtquellenanordnung 1750 angeordnet ist. Im Allgemeinen kann die Lichtquellenanordnung 1750 auf unterschiedlichste Arten und Weisen ausgestaltet sein und unterschiedliche Elemente umfassen; z.B. könnte die Lichtquellenanordnung 1750 weniger oder mehr Element umfassen, als in FIGs. 17 und 18 dargestellt. In dem Beispiel der FIGs. 17 und 18 umfasst die Lichtquellenanordnung 1750 eine Anzeigevorrichtung 1751 wie z.B. eine Leuchtdioden(LED)-Anzeige, eine Anzeige mit organischer LED (OLED) Technologie oder eine Flüssigkristall(LCD)-Anzeige. Z.B. könnte die Anzeigevorrichtung auf eine LCDauf-Sizilium (engl. Liquid Crystal on Silicon, LCOS) Anzeige umfassen; dieses könnte z.B. insbesondere im Zusammenhang mit einem Polteiler und einer LED-Beleuchtung eingesetzt werden, die im Strahlengang hinter der Anzeigevorrichtung und in Richtung des Brillenglases 100 angeordnet sind. Es könnte als Anzeigevorrichtung 1751 auch eine Laserlichtquelle verwendet werden, z.B. in Kombination mit einer Abrasterungsvorrichtung wie einem beweglichen Spiegel, um den Lichtstrahl über die Netzhaut eines Auges eines Benutzers zu rastern.

Die Lichtquellenanordnung 1750 in dem Beispiel der FIGs. 17 und 18 weist ferner ein Filterelement 1752 auf, welches Licht wellenlängenspezifisch filtert. Z.B. kann das Filterelement 1752 ein Bandpass-Filterelement sein, dass selektiv Licht in einem bestimmten Wellenlängenband durchlässt. Insbesondere das Filterelement 1752 ist optional.

Die Lichtquellenanordnung 1750 umfasst weiterhin eine Optikvorrichtung 1753. Die Optikvorrichtung 1753 ist eingerichtet, um Licht in Richtung des HOEs 900 zu lenken, das sich in dem Brillenglas 100 befindet. Dazu könnte die Optikvorrichtung 1753 z.B. ein oder mehrere Linsen umfassen. Die Optikvorrichtung 1753 könnte alternativ oder zusätzlich auch ein oder mehrere Spiegel umfassen, z.B. einen oder mehrere bewegliche Spiegel.

Derart kann erreicht werden, dass die Lichtquellenanordnung 1750 eingerichtet ist, um Licht in Richtung des Brillenglases 100, insbesondere des HOEs 900 auszusenden.

Die HOE-fähige Polymerschicht 102 bzw. das HOE 900 ist dann eingerichtet, um das ausgesendete Licht zu einem Auge eines Trägers der Datenbrille 1700 hin abzubilden. In dem Szenario der FIG. 17 ist das HOE 900 dazu nahe der Vorderseite 100a des Brillenglases 100 angeordnet; in dem Szenario der FIG. 18 ist das HOE 900 dazu nahe der Rückseite 100b des Brillenglases 100 angeordnet. Hierbei sind in dem Szenario der FIG. 17 die Lichtquellenanordnung 1750 und das Brillenglas 100 so zueinander angeordnet, dass der Strahlengang des Lichts von der Lichtquellenanordnung 1750 zu dem HOE 900 innerhalb des Substrats 101 des Brillenglases 100 verläuft; hierbei kann interne Reflektion an den Oberflächen 100a, 100b des Brillenglases 100 zur Strahlführung verwendet werden (in FIG. 17 mit der gestrichelten Linie indiziert). In dem Szenario der FIG. 18 sind die Lichtquellenanordnung 1750 und das Brillenglas 100 so zueinander angeordnet, dass der Strahlengang des Lichts von der Lichtquellenanordnung 1750 zu dem HOE 900 auch außerhalb des Substrats 101 des Brillenglases 100 verläuft.

Selbstverständlich können die Merkmale der vorab beschriebenen Ausführungsformen und Aspekte der Erfindung miteinander kombiniert werden. Insbesondere können die Merkmale nicht nur in den beschriebenen Kombinationen, sondern auch in anderen Kombinationen oder für sich genommen verwendet werden, ohne die in den Ansprüchen definierte Erfindung zu verlassen.

Obenstehend wird der Begriff "Brillenglas" der Einfachheit halber gewählt und ist hinsichtlich des Materials nicht als einschränkend zu werten. Insbesondere kann das Brillenglas auch aus einem oder mehreren Kunststoffen gefertigt sein.

## Patentansprüche

1. Verfahren zur Herstellung eines Brillenglases (100), das eine HOE-fähige Polymerschicht (102) umfasst, wobei die HOE-fähige Polymerschicht (102) geeignet ist, um ein Holographisch-Optisches-Element (900) auszubilden,
wobei das Verfahren umfasst:
- Beschichten eines Trägers (105) mit einem Vorprodukt der HOE-fähigen Polymerschicht (102),
- Umwandeln des Vorprodukts, das auf dem Träger (105) angeordnet ist, zum Erhalten der HOE-fähigen Polymerschicht (102),
- ortsaufgelöstes Belichten der HOE-fähigen Polymerschicht (102), um das Holographisch-Optische-Element (900) auszubilden,
wobei das ortsaufgelöste Belichten umfasst:
- Erhalten von Geometriedaten, welche eine Geometrie des Substrats (101) des Brillenglases (100) beschreiben,
- in Abhängigkeit der Geometriedaten, Bestimmen von Steuerdaten, welche eine Intensität und Phase des ortsaufgelösten Belichtens beschreiben,
- nach dem ortsaufgelösten Belichten der HOE-fähigen Polymerschicht: Fixieren der HOE-fähigen Polymerschicht (102) auf einem transparenten Substrat (101) des Brillenglases (100).

2. Verfahren nach Anspruch 1,
wobei das Fixieren der HOE-fähigen Polymerschicht (102) durch Verkleben und/oder Laminieren erfolgt.

3. Verfahren nach Anspruch 2,
wobei das Verfahren nach dem Fixieren der HOE-fähigen Polymerschicht (102) auf dem transparenten Substrat (101) weiterhin umfasst:
- Entfernen des Trägers (105) von der HOE-fähigen Polymerschicht (102).

4. Verfahren nach einem der voranstehenden Ansprüche, wobei das Verfahren weiterhin umfasst:
- Aufbringen zumindest einer von einer Hartschicht (103-1), einer Antireflex-Schicht (103-2) und einer Clean-Coat-Schicht auf der HOE-fähigen Polymerschicht (102).

5. Verfahren nach Anspruch 4,
wobei das ortsaufgelöste Belichten der HOE-fähigen Polymerschicht (102) nach dem Aufbringen der zumindest einen der Hartschicht (103-1), der Antireflex-Schicht (103-2) und der Clean-Coat-Schicht erfolgt.

6. Verfahren nach einem der voranstehenden Ansprüche,
wobei das Vorprodukt und/oder die HOE-fähige Polymerschicht (102) eine fotoreaktive Komponente und/oder ein HOE-Polymer und/oder eine Polymermatrix umfassen,
wobei das Verfahren optional weiterhin umfasst:
- Aufbringen einer Primer-Schicht (105), die die Polymermatrix und/oder ein weiteres Polymer umfasst, auf dem Substrat (101).

## Claims

1. Method for producing a spectacle lens (100) comprising an HOE-capable polymer layer (102), wherein the HOE-capable polymer layer (102) is suitable for forming a holographic optical element (900),
wherein the method comprises:
- coating a carrier (105) with a precursor of the HOE-capable polymer layer (102),
- converting the precursor that is arranged on the carrier (105), to obtain the HOE-capable polymer layer (102),
- spatially resolved exposure of the HOE-capable polymer layer (102) to form the holographic optical element (900),
wherein the spatially resolved exposure comprises:
- obtaining geometric data describing a geometry of the substrate (101) of the spectacle lens (100),
- depending on the geometric data, determining control data describing an intensity and a phase of the spatially resolved exposure,
- after the spatially resolved exposure of the HOE-capable polymer layer: fixing the HOE-capable polymer layer (102) on a transparent substrate (101) of the spectacle lens (100).

2. Method according to Claim 1,
wherein the fixing of the HOE-capable polymer layer (102) is effected by adhesive bonding and/or laminating.

3. Method according to Claim 2,
wherein the method after fixing of the HOE-capable polymer layer (102) on the transparent substrate (101) further comprises:
- removing the carrier (105) from the HOE-capable polymer layer (102).

4. Method according to any of the preceding claims, wherein the method further comprises:
- applying at least one of a hard layer (103-1), an antireflective layer (103-2) and a clean-coat layer to the HOE-capable polymer layer (102).

5. Method according to Claim 4,
wherein the spatially resolved exposure of the HOE-capable polymer layer (102) is effected after application of the at least one of the hard layer (103-1), the antireflective layer (103-2) and the clean-coat layer.

6. Method according to any of the preceding claims,
wherein the precursor and/or the HOE-capable polymer layer (102) comprise a photoreactive component and/or an HOE polymer and/or a polymer matrix,
wherein the method optionally further comprises:
- applying a primer layer (105) comprising the polymer matrix and/or a further polymer to the substrate (101).

## Revendications

1. Procédé de fabrication d'un verre de lunettes (100) comprenant une couche de polymère compatible HOE (102), la couche de polymère compatible HOE (102) étant adaptée pour réaliser un élément optique holographique (900),
le procédé comprenant :
- le revêtement d'un support (105) avec un précurseur de la couche de polymère compatible HOE (102),
- la transformation du précurseur agencé sur le support (105) pour obtenir la couche de polymère compatible HOE (102),
- l'exposition à résolution spatiale de la couche de polymère compatible HOE (102) pour réaliser l'élément optique holographique (900),
l'exposition à résolution spatiale comprenant :
- l'obtention de données géométriques décrivant une géométrie du substrat (101) du verre de lunettes (100),
- en fonction des données géométriques, la détermination de données de commande décrivant une intensité et une phase de l'exposition à résolution spatiale,
- après l'exposition à résolution spatiale de la couche de polymère compatible HOE : la fixation de la couche de polymère compatible HOE (102) sur un substrat transparent (101) du verre de lunettes (100).

2. Procédé selon la revendication 1,
la fixation de la couche de polymère compatible HOE (102) étant effectuée par collage et/ou stratification.

3. Procédé selon la revendication 2,
le procédé comprenant en outre, après la fixation de la couche de polymère compatible HOE (102) sur le substrat transparent (101) :
- le retrait du support (105) de la couche de polymère compatible HOE (102).

4. Procédé selon l'une quelconque des revendications précédentes, le procédé comprenant en outre :
- l'application d'au moins une couche parmi une couche dure (103-1), une couche antireflet (103-2) et une couche de revêtement autonettoyant sur la couche de polymère compatible HOE (102).

5. Procédé selon la revendication 4,
l'exposition à résolution spatiale de la couche de polymère compatible HOE (102) étant effectuée après l'application de l'au moins une couche parmi la couche dure (103-1), la couche antireflet (103-2) et la couche de revêtement autonettoyant.

6. Procédé selon l'une quelconque des revendications précédentes,
le précurseur et/ou la couche de polymère compatible HOE (102) comprenant un composant photoréactif et/ou un polymère HOE et/ou une matrice polymère,
le procédé comprenant en outre, de manière facultative :
- l'application d'une couche d'apprêt (105) comprenant la matrice polymère et/ou un autre polymère sur le substrat (101).
